# EUROPEAN PATENT APPLICATION

(11) **EP 4 425 556 A1**
(43) Date of publication of application: **04.09.2024**
(21) Application number: 24159724.4
(22) Date of filing: 26.02.2024
(51) Int. Cl.: H01L 27/12, H01L 29/417

(54) **DISPLAY APPARATUS**

(30) Priority: 28.02.2023 KR 20230026632
(71) Applicant: LG Display Co., Ltd., Seoul 07336 (KR)
(72) Inventor: KIM, Kwang-Soo, Paju-si 10845 (KR); SHIN, Hong-Jae, Paju-si 10845 (KR); KIM, Yong-Ho, Paju-si 10845 (KR)
(74) Representative: Morrall, Jonathan Ian McLachlan

(57) **Abstract**

A display device includes: a substrate having a display area including a subpixel and a non-display area surrounding the display area; a driving transistor and a light emitting diode in the subpixel on the substrate; and a second stage transistor in the non-display area on the substrate, wherein the second stage transistor includes a second active layer, a second gate electrode, a second source electrode and a second drain electrode, and wherein a gate insulating layer between the second active layer and the second source electrode and between the second active layer and the second drain electrode exposes the second active layer and has a plurality of second gate insulating layer holes in a zigzag line along a horizontal direction parallel to the second source electrode and the second drain electrode.

## Description

### CROSS-REFERENCE TO RELATED APPLICATIONS

The present application claims the priority benefit of Korean Patent Application No. 10-2023-0026632, filed in Republic of Korea on February 28, 2023, which is hereby incorporated by reference herein in its entirety into the present application.

### BACKGROUND

### Technical Field

The present disclosure relates to a display device, and more particularly, to a display device where an electric disconnection of a source electrode and a drain electrode is prevented by forming a gate insulating layer hole of a stage transistor in a non-display area as a zigzag shape.

### Discussion of the Related Art

Recently, with the advent of an information-oriented society, the interest in information displays for processing and displaying a massive amount of information and the demand for portable information media have increased. As such, a display field has rapidly advanced. Thus, various light and thin flat panel display devices have been developed and highlighted.

Among the various flat panel display devices, an organic light emitting diode (OLED) display device is an emissive type device that does not include a backlight unit used in a non-emissive type device such as a liquid crystal display (LCD) device. As a result, the OLED display device has advantages in a viewing angle, a contrast ratio and a power consumption to be applied to various fields.

In the OLED display device, since both sides of a source electrode and a drain electrode of a stage transistor in a non-display area are disposed in a gate insulating layer hole due to a misalignment, the source electrode and the drain electrode in the gate insulating layer hole may be electrically disconnected while the source electrode and the drain electrode are etched, and the stage transistor in the non-display area may malfunction.

### SUMMARY OF THE DISCLOSURE

Accordingly, the present disclosure is directed to a display device that substantially obviates one or more of the problems due to limitations and disadvantages of the related art.

An object of the present disclosure is to provide a display device where an electric disconnection of a source electrode and a drain electrode is prevented by forming a gate insulating layer hole of a stage transistor in a non-display area as a zigzag shape.

Another object of the present disclosure is to provide a display device where a property uniformity of a stage transistor is improved due to prevention of an electric disconnection of a source electrode and a drain electrode of a stage transistor in a non-display area and improvement of a uniformity of a contact resistance even when a misalignment occurs by disposing one side of the source electrode and the drain electrode in one of two adjacent gate insulating holes and disposing the other side of the source electrode and the drain electrode in the other of the two adjacent gate insulating holes.

Additional features and advantages of the disclosure will be set forth in the description which follows, and in part will be apparent from the description, or can be learned by practice of the disclosure. These and other advantages of the disclosure will be realized and attained by the structure particularly pointed out in the written description and claims hereof as well as the appended drawings.

To achieve these and other advantages and in accordance with the purpose of the present disclosure, as embodied and broadly described herein, a display device includes: a substrate having a display area including a subpixel and a non-display area surrounding the display area; a driving transistor and a light emitting diode in the subpixel on the substrate; and a second stage transistor in the non-display area on the substrate, wherein the second stage transistor includes a second active layer, a second gate electrode, a second source electrode and a second drain electrode, and wherein a gate insulating layer between the second active layer and the second source electrode and between the second active layer and the second drain electrode exposes the second active layer and has a plurality of second gate insulating layer holes in a zigzag line along a horizontal direction parallel to the second source electrode and the second drain electrode.

It is to be understood that both the foregoing general description and the following detailed description are explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this specification, illustrate examples of the disclosure and together with the description serve to explain the principles of the disclosure. In the drawings:
FIG. 1 is a view showing a display device according to an example of the present disclosure;
FIG. 2 is block diagram showing first and second gate driving units and a display panel of a display device according to an example of the present disclosure;
FIG. 3 is a circuit diagram showing a subpixel of a display device according to an example of the present disclosure;
FIG. 4 is a circuit diagram showing a subpixel of a 3T1C structure of a display device according to an example of the present disclosure;
FIG. 5 is a cross-sectional view showing a subpixel of a display device according to an example of the present disclosure;
FIG. 6 is a plan view showing a first stage transistor in a non-display area of a display device according to an example of the present disclosure,'
FIGs. 7A to 7E are views showing a method of fabricating a first stage transistor in a non-display area of a display device according to an example of the present disclosure;
FIG. 8 is a plan view showing a second stage transistor in a non-display area of a display device according to an example of the present disclosure;
FIGs. 9A to 9C are magnified views showing upper, central and lower portions, respectively, of FIG. 8; and
FIGs. 10A to 10E are cross-sectional views showing a method of fabricating a second stage transistor in a non-display area of a display device according to an example of the present disclosure.

### DETAILED DESCRIPTION OF THE EXAMPLES

Advantages and features of the present disclosure, and implementation methods thereof will be clarified through following examples described with reference to the accompanying drawings. The present disclosure may, however, be embodied in different forms and should not be construed as limited to the examples set forth herein. Rather, these examples are provided so that this disclosure can be sufficiently thorough and complete to assist those skilled in the art to fully understand the scope of the present disclosure. Further, the present disclosure is only defined by scopes of claims.

The shapes, sizes, ratios, angles, numbers, and the like, which are illustrated in the drawings to describe various examples of the present disclosure, are merely given by way of example. Therefore, the present disclosure is not limited to the illustrations in the drawings. Like reference numerals refer to like elements throughout the specification, unless otherwise specified.

In the following description, where the detailed description of the relevant known function or configuration may unnecessarily obscure a feature or aspect of the present disclosure, a detailed description of such known function or configuration may be omitted or a brief description may be provided.

Where the terms "comprise," "have," "include," and the like are used, one or more other elements may be added unless the term, such as "only," is used. An element described in the singular form is intended to include a plurality of elements, and vice versa, unless the context clearly indicates otherwise.

In construing an element, the element is to be construed as including an error or a tolerance range even where no explicit description of such an error or tolerance range is provided.

Where positional relationships are described, for example, where the positional relationship between two parts is described using "on," "over," "under," "above," "below," "beside," "next," or the like, one or more other parts may be located between the two parts unless a more limiting term, such as "immediate(ly)," "direct(ly)," or "close(ly)" is used. For example, where an element or layer is disposed "on" another element or layer, a third layer or element may be interposed therebetween.

Although the terms "first," "second," A, B, (a), (b), and the like may be used herein to refer to various elements, these elements should not be interpreted to be limited by these terms as they are not used to define a particular order or precedence. These terms are only used to distinguish one element from another. For example, a first element could be termed a second element, and, similarly, a second element could be termed a first element, without departing from the scope of the present disclosure.

The term "at least one" should be understood to include all combinations of one or more of related elements. For example, the term of " at least one of first, second and third elements" may include all combinations of two or more of the first, second and third elements as well as the first, second or third element.

The term "display device" may include a display device in a narrow sense such as liquid crystal module (LCM), an organic light emitting diode (OLED) module and a quantum dot (QD) module including a display panel and a driving unit for driving the display panel. In addition, the term "display device" may include a complete product (or a final product) including the LCM, the OLED module and the QD module such as a notebook computer, a television, a computer monitor, an equipment display device including an automotive display apparatus or a shape other than a vehicle, and a set electronic apparatus or a set device (or a set apparatus) such as a mobile electronic apparatus of a smart phone or an electronic pad.

Accordingly, a display device of the present disclosure may include an applied product or a set device of a final user's device including the LCM, the OLED module and the QD module as well as a display device in a narrow sense such as the LCM, the OLED module and the QD module.

According to circumstances, the LCM, the OLED module and the QD module having a display panel and a driving unit may be expressed as "a display device", and an electronic apparatus of a complete product including the LCM, the OLED module and the QD module may be expressed as "a set device." For example, a display device in a narrow sense may include a display panel of a liquid crystal, an organic light emitting diode and a quantum dot and a source printed circuit board (PCB) of a control unit for driving the display panel, and a set device may further include a set PCB of a set control unit electrically connected to the source PCB for controlling the entire set device.

The display panel of the present disclosure may include all kinds of display panels such as a liquid crystal display panel, an organic light emitting diode display panel, a quantum dot display panel and an electroluminescent display panel. The display panel of the present disclosure is not limited to a specific display panel of a bezel bending having a flexible substrate for an organic light emitting diode display panel and a lower back plate supporter. A shape or a size of the display panel for the display device of the present disclosure is not limited thereto.

For example, when the display panel is an organic light emitting diode display panel, the display panel may include a plurality of gate lines, a plurality of data lines and a subpixel in a crossing region of the plurality of gate lines and the plurality of data lines. The display panel may include an array having a thin film transistor of an element for selectively applying a voltage to each subpixel, an emitting element layer on the array and an encapsulating substrate or an encapsulation part covering the emitting element layer. The encapsulation part may protect the thin film transistor and the emitting element layer from an external impact and may prevent or at least reduce penetration of a moisture or an oxygen into the emitting element layer. In addition, a layer on the array may include an inorganic light emitting layer, for example, a nano-sized material layer or a quantum dot.

The thin film transistor of the present disclosure may include one of an oxide thin film transistor, an amorphous silicon thin film transistor, a low temperature polycrystalline silicon thin film transistor.

Features of various examples of the present disclosure may be partially or entirely coupled to or combined with each other. They may be linked and operated technically in various ways as those skilled in the art can sufficiently understand. The examples may be carried out independently of or in association with each other in various combinations.

Hereinafter, a display device according to various examples of the present disclosure where an influence on an oxide semiconductor layer of a thin film transistor of a driving element part is reduced by shielding a light emitted and transmitted from a subpixel and/or a light inputted from an exterior will be described in detail with reference to the accompanying drawings.

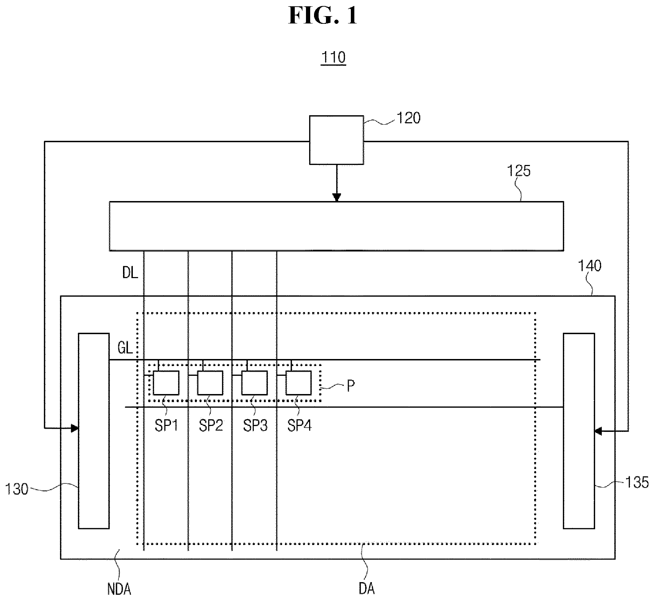

FIG. 1 is a view showing a display device according to an example of the present disclosure. The display device may be an organic light emitting diode (OLED) display device.

In FIG. 1, a display device 110 according to an example of the present disclosure includes a timing controlling unit 120, a data driving unit 125, first and second gate driving units 130 and 135 and a display panel 140.

The timing controlling unit 120 generates an image data, a data control signal and a gate control signal using an image signal and a plurality of timing signals including a data enable signal, a horizontal synchronization signal, a vertical synchronization signal and a clock signal transmitted from an external system such as a graphic card or a television system. The image data and the data control signal are transmitted to the data driving unit 125, and the gate control signal is transmitted to the first and second gate driving units 130 and 135.

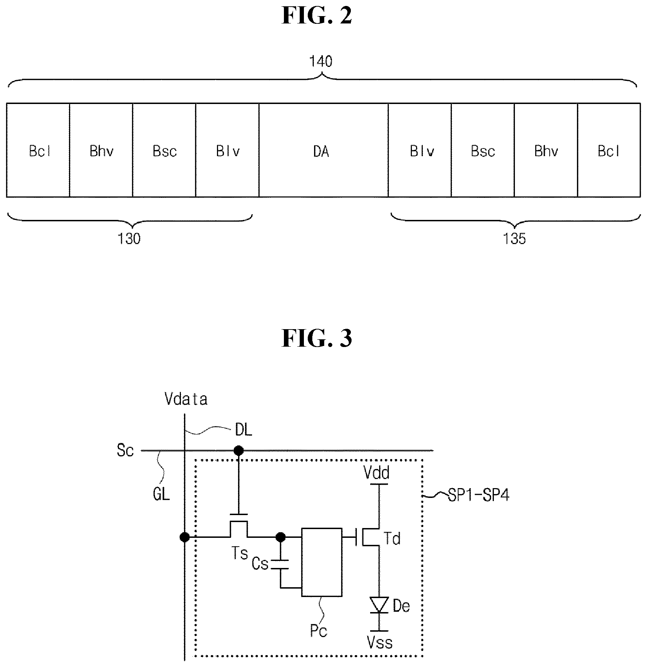

The data driving unit 125 generates a data signal (a data voltage) Vdata (of FIG. 2) using the data control signal and the image data transmitted from the timing controlling unit 120 and transmits the data signal to a data line DL of the display panel 140.

The first and second gate driving units 130 and 135 generate a gate signal (a gate voltage) using the gate control signal transmitted from the timing controlling unit 120 and applies the gate signal to a gate line GL of the display panel 140.

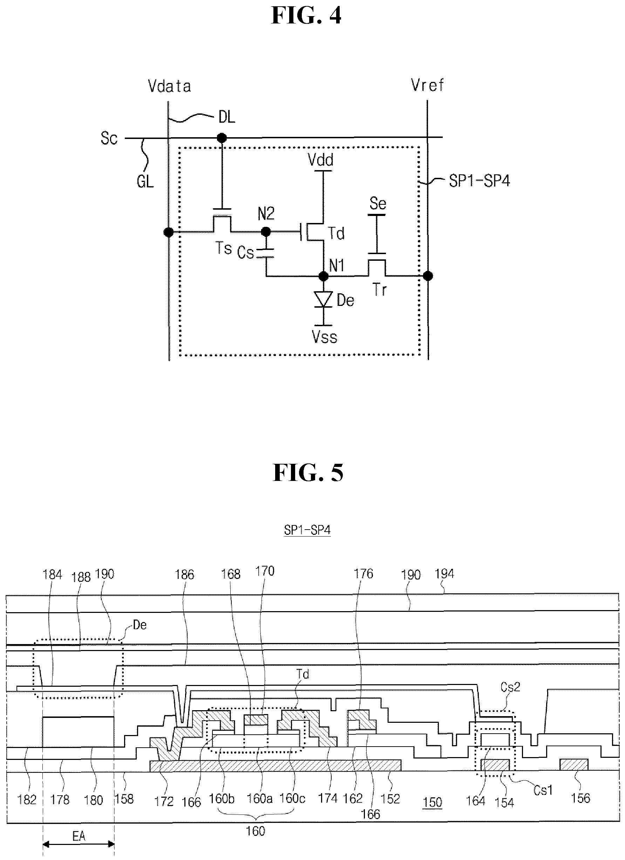

For example, the gate signal may include a scan signal Sc (of FIG. 4), a sensing signal Se (of FIG. 4) and an emission signal.

The first and second gate driving units 130 and 135 may be a gate in panel (GIP) type formed in a non-display area NDA of a substrate of the display panel 140 having the gate line GL, the data line DL and a pixel P.

Although the first and second gate driving units 130 and 135 are disposed in both side portions of the display panel 140 in the example of FIG. 1, one gate driving unit may be disposed in one side portion of the display panel 140 in another example.

The display panel 140 includes a display area DA at a central portion thereof and a non-display area NDA adjacent to and surrounding the display area DA. The display panel 140 displays an image using the gate signal and the data signal Vdata. For displaying an image, the display panel 140 includes a plurality of pixels P, a plurality of gate lines GL and a plurality of data lines DL in the display area DA.

Each of the plurality of pixels P includes first, second, third and fourth subpixels SP1, SP2, SP3 and SP4, and the gate line GL and the data line DL cross each other to define the first, second, third and fourth subpixels SP1, SP2, SP3 and SP4. Each of the first, second, third and fourth subpixels SP1, SP2, SP3 and SP4 is connected to the gate line GL and the data line DL. For example, the first, second, third and fourth subpixels SP1, SP2, SP3 and SP4 may correspond to red, green, blue and white, respectively.

When the display device 110 is an OLED display device, each of the first, second, third and fourth subpixels SP1, SP2, SP3 and SP4 may include a plurality of transistors such as a switching transistor Ts (of FIG. 4), a driving transistor Td (of FIG. 4) and a reference transistor Tr (of FIG. 4), a storage capacitor Cs (of FIG. 4) and a light emitting diode De (of FIG. 4).

A structure and an operation of the first and second gate driving units 130 and 135 and the first, second, third and fourth subpixels SP1, SP2, SP3 and SP4 of the display device 110 will be illustrated with reference to a drawing.

FIG. 2 is block diagram showing first and second gate driving units and a display panel of a display device according to an example of the present disclosure, and FIG. 3 is a circuit diagram showing a subpixel of a display device according to an example of the present disclosure. The display device 110 may be an organic light emitting diode (OLED) display device.

In FIG. 2, each of the first and second gate driving units 130 and 135 of the display device 110 according to an example of the present disclosure includes a clock signal block Bcl, a high level voltage block Bhv, a stage circuit block Bsc and a low level voltage block Blv, and the display area DA is disposed between the first and second gate driving units 130 and 135.

In another example, the disposition structure of the clock signal block Bcl, the high level voltage block Bhv, the stage circuit block Bsc and the low level voltage block Blv in the first and second gate driving units 130 and 135 may be variously changed.

Each of the first and second gate driving units 130 and 135 may include a shift register including a plurality of stages connected to each other in a cascade type.

The clock signal block Bcl includes a plurality of clock lines transmitting a clock signal used in the stage circuit block Bsc.

For example, the clock signal may include a carry clock transmitted between one stage and another stage of the shift register, a scan clock used for generation of the scan signal Sc of the gate signal supplied to the display area DA of the display panel 140 and a sensing clock used for generation of the sensing signal Se of the gate signal supplied to the display area DA of the display panel 140.

The clock signal block Bcl may include a carry clock block including the clock line transmitting the carry clock, a scan clock block including the clock line transmitting the scan clock and a sensing clock block including the clock line transmitting the sensing clock.

The high level voltage block Bhv includes a plurality of power lines transmitting the high level voltage and the control signal of the first and second gate driving units 130 and 135.

For example, the high level voltage of the first and second gate driving units 130 and 135 may include a high level voltage for a shift register and a high level voltage for an inverter of each stage, and the control signal of the first and second gate driving units 130 and 135 may include a start signal corresponding to an operation start of a first stage, a reset signal corresponding to an operation end of a last stage and a real time signal used for generation of a compensation signal in an operation for a real time compensation.

The stage circuit block Bsc as one stage of the shift register generates and outputs the gate signal including the carry signal, the scan signal Sc and the sensing signal Se. The carry signal is transmitted to the other stage, and the scan signal Sc and the sensing signal Se are transmitted to the display area DA.

For example, the stage circuit block Bsc may include a compensation block for an operation of a real time operation, a carry block including a line transmitting the carry signal to the other stage, a logic block substantially generating a plurality of output signals and a buffer block outputting the scan signal Sc and the sensing signal Se of the gate signal supplied to the display area DA of the display panel 140.

The stage block Bsc may include a plurality of transistors and a plurality of capacitors.

The low level voltage block Blv includes the plurality of power lines transmitting the low level voltage of the first and second gate driving units 130 and 135.

In the first and second gate driving units 130 and 135, the stage block Bsc generates the carry signal, the scan signal Sc and the sensing signal Se using the carry clock, the scan clock and the sensing clock transmitted from the clock signal block Bcl. The carry signal is transmitted to the other stage circuit block Bsc, and the scan signal Sc and the sensing signal Se are transmitted to each subpixel SP1, SP2, SP3 and SP4 of the display area DA.

In FIG. 3, each of the first, second, third and fourth subpixels SP1, SP2, SP3 and SP4 of the display panel 140 of the display device 110 according to an example of the present disclosure includes a switching transistor Ts, a driving transistor Td, a compensation part Pc, a storage capacitor Cs and a light emitting diode De. The switching transistor Ts and the driving transistor Td may be an oxide semiconductor thin film transistor or a low temperature polycrystalline silicon thin film transistor.

The switching transistor Ts is switched according to the scan signal Sc of the gate signal. A gate electrode of the switching transistor Ts is connected to the scan signal Sc, a source electrode of the switching transistor Ts is connected to a first capacitor electrode of the storage capacitor Cs and the compensation part Pc, and a drain electrode of the switching transistor Ts is connected to the data signal Vdata.

The driving transistor Td is switched according to a voltage of the compensation part Pc. A gate electrode of the driving transistor Td is connected to the compensation part Pc, a source electrode of the driving transistor Td is connected to an anode of the light emitting diode De, and a drain electrode of the driving transistor Td is connected to the high level voltage Vdd.

The compensation part Pc is connected among the switching transistor Ts, the driving transistor Td and the storage capacitor Cs and compensates a variation of the threshold voltage Vth of the driving transistor Td.

The storage capacitor Cs stores the data signal Vdata. A first capacitor electrode of the storage capacitor Cs is connected to the source electrode of the switching transistor Ts and the compensation part Pc, and a second capacitor electrode of the storage capacitor Cs is connected to the compensation part Pc.

The light emitting diode De is connected between the driving transistor Td and the low level voltage Vss and emits a light of a luminance proportional to a current of the driving transistor Td. An anode of the light emitting diode De is connected to the source electrode of the driving transistor Td, and a cathode of the light emitting diode De is connected to the low level voltage Vss.

The data signal Vdata is supplied from the data driving unit 125 to each subpixel SP1, SP2, SP3 and SP4 of the display panel 140, and the scan signal Sc of the gate signal is supplied from the first and second gate driving units 130 and 135 to each subpixel SP1, SP2, SP3 and SP4 of the display panel 140.

Each of the first, second, third and fourth subpixels SP1, SP2, SP3 and SP4 may have one of 3T1C structure including three transistors and one capacitor, 6T1C structure including six transistors and one capacitor, 7T1C structure including seven transistors and one capacitor and 8T1C structure including eight transistors and one capacitor.

A 3T1C structure of each subpixel SP1, SP2, SP3 and SP4 will be illustrated with reference to a drawing.

FIG. 4 is a circuit diagram showing a subpixel of a 3T1C structure of a display device according to an example of the present disclosure.

In FIG. 4, each of the first, second, third and fourth subpixels SP1, SP2, SP3 and SP4 of the display panel 140 of the display device 110 according to an example of the present disclosure includes a switching transistor Ts, a driving transistor Td, a reference transistor Tr, a storage capacitor Cs and a light emitting diode De. The switching transistor Ts, the driving transistor Td and the reference transistor Tr may be an oxide semiconductor thin film transistor or a low temperature polycrystalline silicon thin film transistor.

The switching transistor Ts is switched according to a scan signal Sc of the gate signal. A gate electrode of the switching transistor Ts is connected to the scan signal Sc, a source electrode of the switching transistor Ts is connected to a first capacitor electrode of the storage capacitor Cs and a gate electrode of the driving transistor Td, and a drain electrode of the switching transistor Ts is connected to the data signal Vdata.

The driving transistor Td is switched according to a voltage of the first capacitor electrode of the storage capacitor Cs. A gate electrode of the driving transistor is connected to the source electrode of the switching transistor Ts and the first capacitor electrode of the storage capacitor Cs, a source electrode of the driving transistor Td is connected to a second capacitor electrode of the storage capacitor Cs, an anode of the light emitting diode De and a source electrode of the reference transistor Tr, and a drain electrode of the driving transistor Td is connected to the high level voltage Vdd.

The storage capacitor Cs stores the data signal Vdata compensated with a threshold voltage Vth of the driving transistor Td. The first capacitor electrode of the storage capacitor Cs is connected to the source electrode of the switching transistor Ts and the gate electrode of the driving transistor Td, and the second capacitor electrode of the storage capacitor Cs is connected to the source electrode of the driving transistor Td, the source electrode of the reference transistor Tr and the anode of the light emitting diode De.

The light emitting diode De is connected between the driving transistor Td and the low level voltage Vss and emits a light of a luminance proportional to a current of the driving transistor Td. The anode of the light emitting diode De is connected to the source electrode of the driving transistor Td, the second capacitor electrode of the storage capacitor Cs and the source electrode of the reference transistor Tr, and a cathode of the light emitting diode De is connected to the low level voltage Vss.

The data signal Vdata and the reference signal Vref are supplied from the data driving unit 125 to each subpixel SP1 to SP4 of the display panel 140, and the scan signal Sc and the sensing signal Se of the gate signal are supplied from the first and second gate driving units 130 and 135 to each subpixel SP1 to SP4 of the display panel 140.

The source electrode of the driving transistor Td, the source electrode of the reference transistor Tr, the second capacitor electrode of the storage capacitor Cs and the anode of the light emitting diode De are connected to each other to constitute a first node N1, and the gate electrode of the driving transistor Td, the source electrode of the switching transistor Ts and the first capacitor electrode of the storage capacitor Cs are connected to each other to constitute a second node N2.

In the display device 110, during an initialization period where the reference transistor Tr is turned on, the reference signal Vref is supplied to the first node N1 and the first and second nodes N1 and N2 are initialized. During a writing period where the switching transistor Ts is turned on and off, the data signal Vdata is applied to the second node N2 and the threshold voltage of the driving transistor Td is stored in the storage capacitor Cs. During a sensing period where the reference transistor Tr is turned on again, the data driving unit 125 detects the threshold voltage of the driving transistor Td stored in the storage capacitor Cs and transmits the threshold voltage to the timing controlling unit 120.

Next, the timing controlling unit 120 modifies the data signal Vdata to generate a compensated data signal where the threshold voltage is compensated and supply the compensated data signal to each subpixel SP1 to SP4 through the data driving unit 125. During an emission period where the switching transistor Ts is turned on, a current corresponding to the compensated data signal is supplied to the light emitting diode De through the driving transistor Td and the light emitting diode De emits a light.

A cross-sectional structure of each subpixel will be illustrated with reference to a drawing.

FIG. 5 is a cross-sectional view showing a subpixel of a display device according to an example of the present disclosure.

In FIG. 5, each subpixel SP1 to SP4 of the display device 110 according to an example of the present disclosure includes the driving transistor Td and the light emitting diode De.

A light shielding layer 152, a first capacitor pattern 154 and a data line 156 are disposed on a substrate 150.

The substrate 150 may include a glass or a multiple layer where an organic layer and an inorganic layer are alternately laminated. For example, the substrate 150 may include an organic insulating material layer such as polyimide (PI) and an inorganic insulating material layer such as silicon oxide (SiO2) alternately laminated.

The light shielding layer 152, the first capacitor pattern 154 and the data line 156 may have the same layer and the same material as each other through a single mask process. The light shielding layer 152, the first capacitor pattern 154 and the data line 156 may include a metallic material.

For example, the light shielding layer 152, the first capacitor pattern 154 and the data line 156 may have a single layer or a multiple layer including one of molybdenum (Mo), aluminum (Al), chromium (Cr), gold (Au), titanium (Ti), nickel (Ni), neodymium (Nd), copper (Cu) and an alloy thereof.

A buffer layer 158 is disposed on the light shielding layer 152, the first capacitor pattern 154 and the data line 156 over the entire substrate 150. The buffer layer 158 may block a moisture penetrable from an exterior. For example, the buffer layer 158 may have a multiple layer of an inorganic material such as silicon oxide (SiO2).

An active layer 160 and a semiconductor layer 162 are disposed on the buffer layer 158 corresponding to the light shielding layer 152, and a second capacitor pattern 164 is disposed on the buffer layer 158 corresponding to the first capacitor pattern 154.

The active layer 160, the semiconductor layer 162 and the second capacitor pattern 164 may have the same layer and the same material as each other through a single mask process. The active layer 160, the semiconductor layer 162 and the second capacitor pattern 164 may include polycrystalline silicon or oxide semiconductor material.

The active layer 160 may have a channel region 160a at a central portion thereof and source and drain regions 160b and 160c at both side portions of the channel region 160a. The channel region 160a may include an intrinsic semiconductor material without an impurity, and the source and drain regions 160b and 160c may include an impurity doped semiconductor material.

The first capacitor pattern 154, the buffer layer 158 and the second capacitor pattern 164 constitute a first storage capacitor Cs1.

A metal layer 166 is disposed on the source region 160b and 160c of the active layer 160 and on the semiconductor layer 162. The metal layer 166 may be formed simultaneously with the active layer 160 through the same photolithographic process using a half transmissive mask.

For example, the metal layer 166 may include a metallic material such as molybdenum titanium (MoTi).

A patterned gate insulating layer 168 is disposed on the channel region 160a of the active layer 160, on the metal layer 166 corresponding to the source region 160b and the drain region 160c of the active layer 160 and on the metal layer 166 corresponding to the semiconductor layer 162. The gate insulating layer 168 may have a single layer or a multiple layer of an inorganic insulating material such as silicon oxide (SiO2) and silicon nitride (SiNx).

A gate electrode 170 is disposed on the gate insulating layer 168 corresponding to the channel region 160a of the active layer 160, and a source electrode 172 is disposed on the gate insulating layer 168 corresponding to the source region 160b of the active layer 160 and on the metal layer 166. A drain electrode 174 is disposed on the gate insulating layer 168 corresponding to the drain region 160c of the active layer 160 and on the metal layer 166, and a gate line 176 is disposed on the gate insulating layer 168 corresponding to the semiconductor layer 162.

The gate electrode 170, the source electrode 172, the drain electrode 174 and the gate line 176 may have the same layer and the same material as each other through a single mask process. The gate electrode 170, the source electrode 172, the drain electrode 174 and the gate line 176 may include a metallic material.

For example, the gate electrode 170, the source electrode 172, the drain electrode 174 and the gate line 176 may have a single layer or a multiple layer including one of molybdenum (Mo), aluminum (Al), chromium (Cr), gold (Au), titanium (Ti), nickel (Ni), neodymium (Nd), copper (Cu) and an alloy thereof.

The gate electrode 170 does not contact the channel region 160a of the active layer 160. On the other hand, the source electrode 172 contacts the light shielding layer 152 through a contact hole of the buffer layer 158 and contacts the metal layer 166 on the source region 160b of the active layer 160 through a side surface of the gate insulating layer 168. Further, the drain electrode 174 contacts the metal layer 166 on the drain region 160c of the active layer 160 through the side surface of the gate insulating layer 168, and the gate line 176 contacts the metal layer on the semiconductor layer 162 through the side surface of the gate insulating layer 168.

In another example, the metal layer 166 may be omitted, and the source electrode 172 and the drain electrode 174 may directly contact the source region 160b and the drain region 160c, respectively, of the active layer 160.

The active layer 160, the gate insulating layer 168, the gate electrode 170, the source electrode 172 and the drain electrode 174 constitute the driving transistor Td.

An interlayer insulating layer 178 is disposed on the gate electrode 170, the source electrode 172, the drain electrode 174, the gate line 176 and the second capacitor pattern 164 over the entire substrate 150. The interlayer insulating layer 178 may have a single layer or a multiple layer of an inorganic insulating material such as silicon oxide (SiO2) and silicon nitride (SiNx).

A color filter layer 180 is disposed in an emission area EA on the interlayer insulating layer 178. For example, the color filter layer 180 of the first, second, third and fourth subpixels SP1, SP2, SP3 and SP4 may correspond to red, green, blue and white colors, respectively.

An overcoat layer 182 is disposed on the color filter layer 180 over the entire substrate 150. The overcoat layer 182 may include an organic insulating material such as polyimide (PI) and acrylic resin.

A first electrode 184 is disposed on the overcoat layer 182 and is connected to the source electrode 172 through a contact hole in the overcoat layer 182 and the interlayer insulating layer 178. The first electrode 184 may be an anode of a multiple layer including a transparent conductive material.

For example, the transparent conductive material may include a material having a relatively high work function such as indium tin oxide (ITO) and indium zinc oxide (IZO).

The first electrode 184 extends from the emission area EA to overlap the second capacitor pattern 164. The second capacitor pattern 164, the interlayer insulating layer 178 and the first electrode 184 constitute a second storage capacitor Cs2.

The first and second storage capacitors Cs1 and Cs2 are connected to each other in parallel to constitute the storage capacitor Cs (of FIG. 3).

A bank layer 186 is disposed on the first electrode 184 to cover an edge portion of the first electrode 184. The bank layer 186 has an opening exposing a central portion of the first electrode 184, and the opening of the bank layer 186 corresponds to the emission area EA.

For example, the bank layer 186 may include an opaque material (e.g. black material) to prevent a light interference between the adjacent subpixels SP1 to SP4. The bank layer 186 may include a shielding material of at least one of a color pigment, an organic black and a carbon.

Although not shown, a spacer may be disposed on the bank layer 186.

An emitting layer 188 is disposed on the bank layer 186 and the first electrode 184 exposed through the opening of the bank layer 186. The emitting layer 188 may include a hole relating layer, an organic emitting layer and an electron relating layer sequentially or reversely laminated.

For example, the emitting layer 188 may include a hole injecting layer, a hole transporting layer, an emitting material layer, an electron transporting layer and an electron injecting layer.

A second electrode 190 is disposed on the emitting layer 188 over the entire substrate 150. The second electrode 190 may be a cathode of a multiple layer including an opaque conductive material having a relatively high reflection efficiency.

For example, the opaque conductive material may include a material having a relatively low work function such as aluminum (Al), silver (Ag), copper (Cu), lead (Pb), molybdenum (Mo), titanium (Ti) and an alloy thereof.

The first electrode 184, the emitting layer 188 and the second electrode 190 constitute the light emitting diode De.

Although the display device 110 has a bottom emission type where the first electrode 184 includes a transparent material and the second electrode 190 has an opaque material having a relatively high reflectance in an example of FIG. 5, the display device 110 may have a top emission type where the first electrode 184 includes an opaque material having a relatively high reflectance and the second electrode 190 includes a transparent material and the color filter layer 180 is disposed on the second electrode 190 in another example.

A first encapsulating layer 192 and a second encapsulating layer 194 are sequentially disposed on the second electrode 190 over the entire substrate 150. The first encapsulating layer 192 and the second encapsulating layer 194 may prevent a moisture or an oxygen of an exterior from permeating the light emitting diode De.

For example, the first encapsulating layer 192 may include a non-photosensitive organic insulating material such as acrylic resin, epoxy resin, phenolic resin, polyamide resin, polyimide resin, polyethylene and silicon oxycarbon (SiOC) or a photosensitive organic insulating material such as photoacryl, and the second encapsulating layer 194 may include a metallic material.

In the display device 110, a gate insulating layer hole of a stage transistor of a stage circuit block Bsc in a non-display area NDA has a zigzag shape.

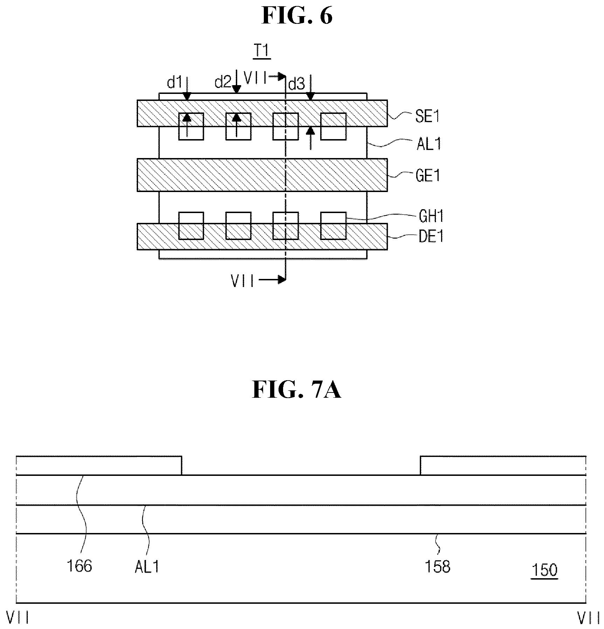

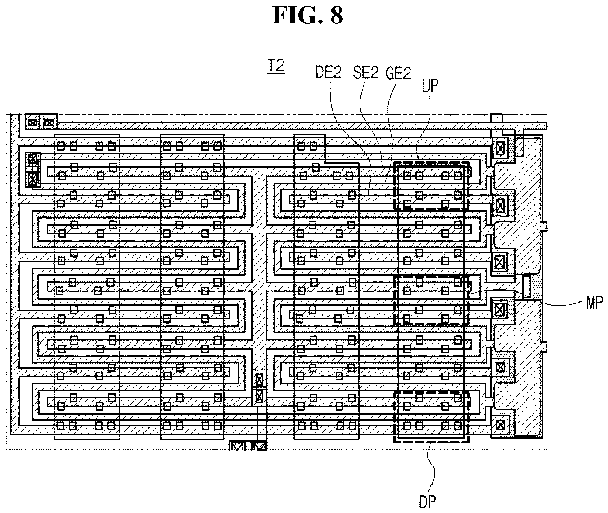

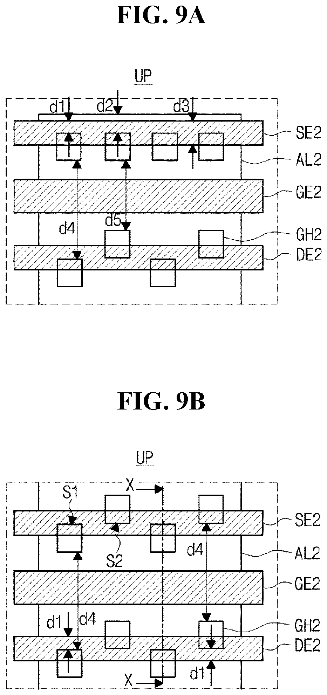

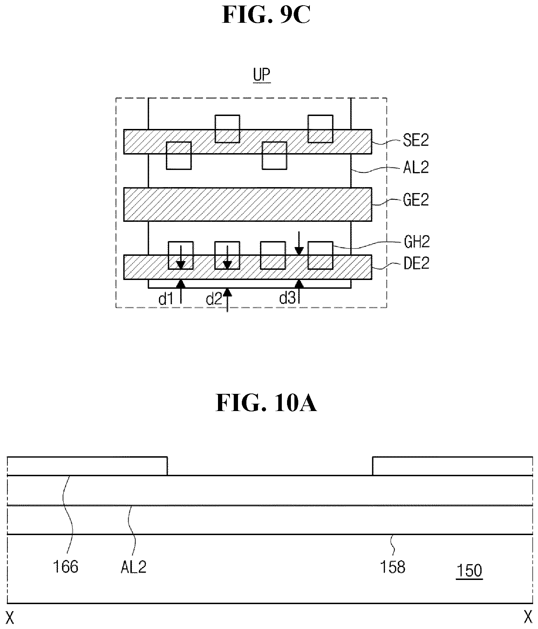

FIG. 6 is a plan view showing a first stage transistor in a non-display area of a display device according to an example of the present disclosure, and FIGs. 7A to 7E are views showing a method of fabricating a first stage transistor in a non-display area of a display device according to an example of the present disclosure. FIG. 8 is a plan view showing a second stage transistor in a non-display area of a display device according to an example of the present disclosure, FIGs. 9A to 9C are magnified views showing upper, central and lower portions, respectively, of FIG. 8, and FIGs. 10A to 10E are cross-sectional views showing a method of fabricating a second stage transistor in a non-display area of a display device according to an example of the present disclosure. FIGs. 7A to 7E are cross-sectional views taken along a line of VII-VII of FIG. 6, and FIGs. 10A to 10E are cross-sectional views taken along a line of X-X of FIG. 9B.

The stage circuit block Bsc of the first and second gate driving units 130 and 135 is disposed in the non-display area NDA of the display panel 140 of the display device 110 according to an example of the present disclosure. The stage circuit block Bsc includes a plurality of stage transistors constituting a single stage of a shift register.

The plurality of stage transistors of the stage circuit block Bsc may be classified into an input reset transistor for charging and discharging a Q node of each stage of the shift register, an inverter transistor for charging and discharging a Qb node using a voltage of a Q node, a buffer transistor for outputting a gate signal using a voltage of a Q node and a stabilization transistor for stabilizing a Q node and a gate signal using a voltage of a Qb node.

Among the plurality of stage transistors of the stage circuit block Bsc, since the input reset transistor, the inverter transistor and the stabilization transistor are used for a logic of the shift register, the input reset transistor, the inverter transistor and the stabilization transistor may include a first stage transistor T1 having the channel region 160a of a linear shape corresponding to a relatively small ratio (W/L) of a channel width (W) to a channel length (L). Since the buffer transistor is used for an output of the shift register, the buffer transistor may include a second stage transistor T2 having the channel region 160a of a bent shape corresponding to a relatively great ratio (W/L) of a channel width (W) to a channel length (L).

For example, the ratio (W/L) of a channel width (W) to a channel length (L) of the second stage transistor T2 may be greater than the ratio (W/L) of a channel width (W) to a channel length (L) of the first stage transistor T1.

In FIG. 6, the first stage transistor T1 includes a first active layer AL1, a first gate electrode GE1, a first source electrode SE1 and a first drain electrode DE1.

The first active layer AL1 has a rectangular shape, and the first gate electrode GE1, the first source electrode SE1 and the first drain electrode DE1 have a bar shape.

The first gate electrode GE1, the first source electrode SE1 and the first drain electrode DE1 are disposed on the first active layer AL1 along a horizontal direction. The first gate electrode GE1, the first source electrode SE1 and the first drain electrode DE1 are spaced apart from and parallel to each other.

The gate insulating layer 168 is disposed between the first active layer AL1 and the first gate electrode GE1, and the gate insulating layer 168 and the metal layer 166 are disposed between the first active layer AL1 and the first source electrode SE1 and between the first active layer AL1 and the first drain electrode DE1. The gate insulating layer 168 exposes the metal layer 166 and has a plurality of first gate insulating layer holes GH1 each having a rectangular shape.

The plurality of first gate insulating holes GH1 are disposed in a straight line along a horizontal direction to overlap one side (lower side) of the first source electrode SE1 and are spaced apart from the other side (upper side) of the first source electrode SE1 not to overlap the other side of the first source electrode SE1.

One side (upper side) of the plurality of first gate insulating layer holes GH1 and the other side (upper side) of the first source electrode SE1 are spaced apart from each other by a first distance d1, and one side (upper side) of the plurality of first gate insulating layer holes GH1 and one side (upper side) of the first active layer AL1 are spaced apart from each other by a second distance d2. The first source electrode SE1 has a width of a third distance d3.

The first distance d1 is a disconnection margin for preventing disconnection of the first source electrode SE1 due to the first gate insulating layer hole GH1. For example, the first distance d1 may be within a range of about 2.0µm to about 4.0µm.

When one side (upper side) of the first gate insulating layer hole GH1 and the other side (upper side) of the first source electrode SE1 are spaced apart from each other by a distance smaller than the first distance d1, the first gate insulating layer hole GH1 may overlap both sides (upper side, lower side) of the first source electrode SE1 due to a misalignment, and the first source electrode SE1 may be disconnected while the first source electrode SE1 and the gate insulating layer 168 are etched.

The second distance d2 is a design margin between the first gate insulating layer hole GH1 and the first active layer AL1. For example, the second distance d2 may be within a range of about 2.5µm to about 4.5µm.

The third distance d3 is a design line width of the first source electrode SE1. For example, the third distance d3 may be within a range of about 5.0µm to about 7.0µm.

The plurality of first gate insulating layer holes GH1 are disposed in a straight line along a horizontal direction to overlap one side (upper side) of the first drain electrode DE1 and are spaced apart from the other side (lower side) of the first drain electrode DE1 not to overlap the other side of the first drain electrode DE1.

One side (lower side) of the plurality of first gate insulating layer holes GH1 and the other side (lower side) of the first drain electrode DE1 are spaced apart from each other by a first distance d1, and one side (lower side) of the plurality of first gate insulating layer holes GH1 and the other side (lower side) of the first active layer AL1 are spaced apart from each other by a second distance d2. The first drain electrode DE1 has a width of a third distance d3.

In FIG. 7A, the buffer layer 158 is formed on the entire substrate 150. Next, after a semiconductor material is deposited on the buffer layer 158 in the non-display area NDA, the first active layer AL1 is formed through a photolithographic process. Next, after a metallic material is deposited on the first active layer AL1, the metal layer 166 is formed on both end portions of the first active layer AL1 through a photolithographic process.

The first active layer AL1 in the non-display area NDA may have the same layer and the same material as the active layer 160 of the subpixel SP1 to SP4 in the display area DA.

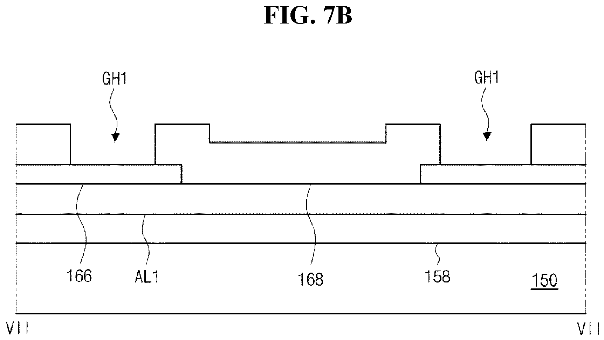

In FIG. 7B, after an insulating material is deposited on the metal layer 166, the gate insulating layer 168 having the plurality of first gate insulating layer holes GH1 is formed through a photolithographic process.

The plurality of first gate insulating layer holes GH1 expose the metal layer 166.

In another example, the metal layer 166 may be omitted, and the plurality of first gate insulating layer holes GH1 may expose the source region and the drain region of the first active layer AL1.

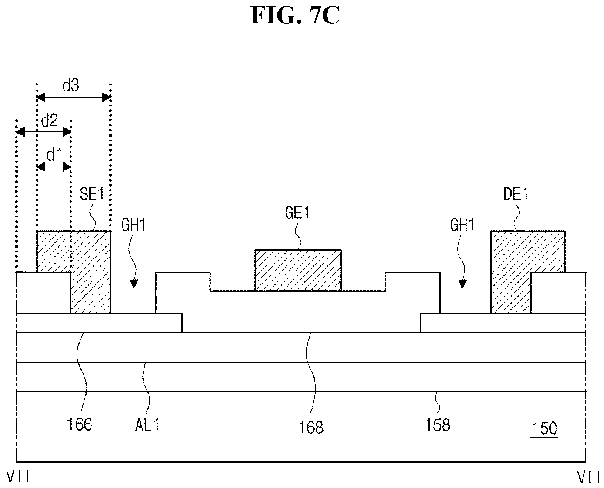

In FIG. 7C, after a metallic material is deposited on the gate insulating layer 168, the first gate electrode GE1, the first source electrode SE1 and the first drain electrode DE1 are formed through a photolithographic process.

The first gate electrode GE1, the first source electrode SE1 and the first drain electrode DE1 in the non-display area NDA may have the same layer and the same material as each other and may have the same layer and the same material as the gate electrode 170, the source electrode 172 and the drain electrode 174 of the subpixel SP1 to SP4 in the display area DA.

For example, the first gate electrode GE1, the first source electrode SE1 and the first drain electrode DE1 may be formed through a wet etching method.

The first gate electrode GE1 is disposed on the gate insulating layer 168, and each of the first source electrode SE1 and the first drain electrode DE1 is disposed to overlap one side of the plurality of first gate insulating holes GE1 and be spaced apart from the other side of the plurality of first gate insulating layer holes GE1.

As a result, each of the first source electrode SE1 and the first drain electrode DE1 may be disposed on the gate insulating layer 168 adjacent to the plurality of first gate insulating layer holes GH1 and on a portion of the metal layer 166 in the plurality of first gate insulating layer holes GH1.

One side of the plurality of first gate insulating layer holes GH1 and the other side of the first source electrode SE1 may be spaced apart from each other by the first distance d1, and one side of the plurality of first gate insulating layer holes GH1 and one side of the first active layer AL1 may be spaced apart from each other by the second distance d2. The first source electrode SE1 may have a width of the third distance d3.

One side of the plurality of first gate insulating layer holes GH1 and the other side of the first drain electrode DE1 may be spaced apart from each other by the first distance d1, and one side of the plurality of first gate insulating layer holes GH1 and the other side of the first active layer AL1 may be spaced apart from each other by the second distance d2. The first drain electrode DE1 may have a width of the third distance d3.

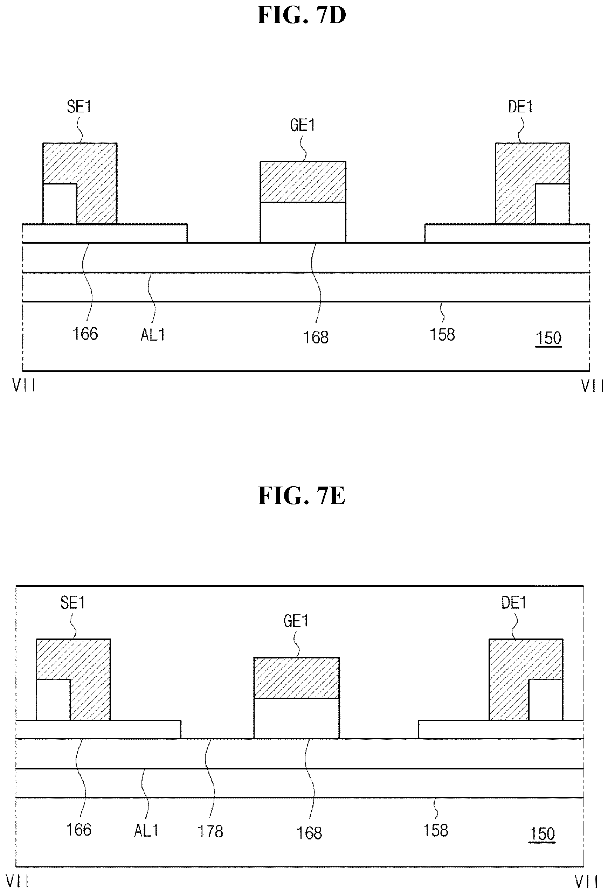

In FIG. 7D, the gate insulating layer 168 is formed under a whole of the first gate electrode GE1, a portion of the first source electrode SE1 and a portion of the first drain electrode DE1 by selectively removing the gate insulating layer 168 exposed outside lower portions of the first gate electrode GE1, the first source electrode SE1 and the first drain electrode DE1 using the first gate electrode GE1, the first source electrode SE1 and the first drain electrode DE1 as an etching mask.

For example, the gate insulating layer 168 may be formed through a dry etching method.

While the first gate electrode GE1, the first source electrode SE1, the first drain electrode DE1 and the gate insulating layer 168 are etched, a side portion (edge portion) of each of the first source electrode SE1 and the first drain electrode DE1 overlapping a sidewall (step difference portion) of the plurality of first gate insulating layer holes GH1 and exposed in the plurality of first gate insulating layer holes GH1 may be eroded by an etchant or an etching gas. When both sides of each of the first source electrode SE1 and the first drain electrode DE1 are disposed in the plurality of first gate insulating layers GH1, each of the first source electrode SE1 and the first drain electrode DE1 may be disconnected.

In the display device 110 according to an example of the present disclosure, one side of each of the first source electrode SE1 and the first drain electrode DE1 is disposed in the plurality of first gate insulating layer holes GH1, and the other side of each of the first source electrode SE1 and the first drain electrode DE1 is disposed outside the plurality of first gate insulating layer holes GH1. As a result, while the first gate electrode GE1, the first source electrode SE1, the first drain electrode DE1 and the gate insulating layer 168 are etched, the disconnection of each of the first source electrode SE1 and the first drain electrode DE1 is reduced or minimized.

In FIG. 7E, the interlayer insulating layer 178 is formed on the first gate electrode GE1, the first source electrode SE1 and the first drain electrode DE1 over the entire substrate 150 to complete the first stage transistor T1.

In FIG. 8, the second stage transistor T2 includes a second active layer AL2, a second gate electrode GE2, a second source electrode SE2 and a second drain electrode DE2.

The second active layer AL2 has a rectangular shape or a bar shape, the second gate electrode GE2 has a zigzag shape, and the second source electrode SE2 and the second drain electrode DE2 have a bar shape.

Although the second active layer AL2 exemplarily has a shape of a plurality of rectangles separated from each other along the horizontal direction in an example of FIG. 8, the second active layer AL2 may have a shape of a plurality of plates connected to each other along the horizontal direction.

The second gate electrode GE2 includes a plurality of gate vertical parts and a plurality of gate horizontal parts connected to each other and symmetrically disposed with respect to a central line along the vertical direction. The left and right gate horizontal parts of an upper end portion are connected to each other, and the left and right gate horizontal parts of a lower end portion are connected to each other.

The second source electrode SE2 includes a source vertical part corresponding to the central line along the vertical direction and a plurality of source horizontal parts extending from the source vertical part along the horizontal direction. The gate horizontal parts are disposed at up and down sides of each of the plurality of source horizontal parts.

The second drain electrode DE2 includes two drain vertical parts at left and right end portions and a plurality of drain horizontal parts extending from the drain vertical part along the horizontal direction. The gate horizontal parts are disposed at up and down sides of each of the plurality of drain horizontal parts.

As a result, the gate horizontal part of the second gate electrode GE2, the source horizontal part of the second source electrode SE2 and the drain horizontal part of the second drain electrode DE2 are disposed on the second active layer AL2 along the horizontal direction. The gate horizontal part of the second gate electrode GE2, the source horizontal part of the second source electrode SE2 and the drain horizontal part of the second drain electrode DE2 are spaced apart from each other and parallel to each other.

The gate insulating layer 168 is disposed between the second active layer AL2 and the second gate electrode GE2, and the gate insulating layer 168 and the metal layer 166 are disposed between the second active layer AL2 and the second source electrode SE2 and between the second active layer AL2 and the second drain electrode DE2. The gate insulating layer 168 exposes the metal layer 166 and has a plurality of second gate insulating layer holes GH2 each having a rectangular shape.

In FIG. 9A, the plurality of second gate insulating holes GH2 corresponding to the second source electrode SE2 in an upper portion UP of the second stage transistor T2 are disposed in a straight line along a horizontal direction to overlap one side (lower side) of the second source electrode SE2 and are spaced apart from the other side (upper side) of the second source electrode SE2 not to overlap the other side of the second source electrode SE2.

One side (upper side) of the plurality of second gate insulating layer holes GH2 corresponding to the second source electrode SE2 and the other side (upper side) of the second source electrode SE2 are spaced apart from each other by the first distance d1, and one side (upper side) of the plurality of second gate insulating layer holes GH2 corresponding to the second source electrode SE2 and one side (upper side) of the second active layer AL2 are spaced apart from each other by the second distance d2. The second source electrode SE2 has a width of the third distance d3.

The first distance d1 is a disconnection margin for preventing disconnection of the second source electrode SE2 due to the second gate insulating layer hole GH2. For example, the first distance d1 may be within a range of about 2.0µm to about 4.0µm.

When one side (upper side) of the second gate insulating layer hole GH2 and the other side (upper side) of the second source electrode SE2 are spaced apart from each other by a distance smaller than the first distance d1, the second gate insulating layer hole GH2 may overlap both sides (upper side, lower side) of the second source electrode SE2 due to a misalignment, and the second source electrode SE2 may be disconnected while the second source electrode SE2 and the gate insulating layer 168 are etched.

The second distance d2 is a design margin between the second gate insulating layer hole GH2 and the second active layer AL2. For example, the second distance d2 may be within a range of about 2.5µm to about 4.5µm.

The third distance d3 is a design line width of the second source electrode SE2. For example, the third distance d3 may be within a range of about 5.0µm to about 7.0µm.

The plurality of second gate insulating layer holes GH2 are disposed in a zigzag line along a horizontal direction. A portion of the plurality of second gate insulating layer holes GH2 corresponding to the second drain electrode DE2 overlaps one side (upper side) of the second drain electrode DE2 and does not overlap the other side (lower side) of the second drain electrode DE2 to be spaced apart from the other side of the second drain electrode DE2. The other portion of the plurality of second gate insulating holes GH2 corresponding to the second drain electrode DE2 does not overlap one side (upper side) of the second drain electrode DE2 to be spaced apart from one side of the second drain electrode DE2 and overlaps the other side (lower side) of the second drain electrode DE2.

One side (lower side) of the portion of the plurality of second gate insulating layer holes GH2 corresponding to the second drain electrode DE2 and the other side (lower side) of the second drain electrode DE2 are spaced apart from each other by the first distance d1, and one side (lower side) of the other portion of the plurality of second gate insulating layer holes GH2 corresponding to the second drain electrode DE2 and one side (upper side) of the second drain electrode DE2 are spaced apart from each other by the first distance d1. The second drain electrode DE2 has a width of the third distance d3.

The other side (lower side) of the plurality of second gate insulating layer holes GH2 corresponding to the second source electrode SE2 and the other side (upper side) of the plurality of second gate insulating layer holes GH2 overlapping the other side (lower side) of the second drain electrode DE2 are spaced apart from each other by a fourth distance d4, and the other side (lower side) of the plurality of second gate insulating layer holes GH2 corresponding to the second source electrode SE2 and the other side (upper side) of the plurality of second gate insulating layer holes GH2 overlapping one side (upper side) of the second drain electrode DE2 are spaced apart from each other by a fifth distance d5. The fourth distance d4 may be greater than the fifth distance d5.

In FIG. 9B, the plurality of second gate insulating layer holes GH2 corresponding to the second source electrode SE2 in an middle portion MP of the second stage transistor T2 are disposed in a zigzag line along a horizontal direction. A portion of the plurality of second gate insulating layer holes GH2 corresponding to the second source electrode SE2 overlaps one side (lower side) of the second source electrode SE2 and does not overlap the other side (upper side) of the second source electrode SE2 to be spaced apart from the other side of the second source electrode SE2. The other portion of the plurality of second gate insulating holes GH2 corresponding to the second source electrode SE2 overlap the other side (upper side) of the second source electrode SE2 and does not overlap one side (lower side) of the second source electrode SE2 to be spaced apart from one side of the second source electrode SE2.

One side (upper side) of the portion of the plurality of second gate insulating layer holes GH2 corresponding to the second source electrode SE2 and the other side (upper side) of the second source electrode SE2 are spaced apart from each other by the first distance d1, and the other side (lower side) of the other portion of the plurality of second gate insulating layer holes GH2 corresponding to the second source electrode SE2 and one side (lower side) of the second source electrode SE2 are spaced apart from each other by the first distance d1. The second source electrode SE2 has a width of the third distance d3.

A first side S1 (upper side) of one of adjacent two of the plurality of second gate insulating layer holes GH2 corresponding to the second source electrode SE2 and a second side (lower side) S2 of the other of the adjacent two of the plurality of second gate insulating layer holes GH2 corresponding to the second source electrode SE2 may be disposed to be coincide with each other along the horizontal direction.

The plurality of second gate insulating layer holes GH2 corresponding to the second drain electrode DE2 are disposed in a zigzag line along the horizontal direction. A portion of the plurality of second gate insulating layer holes GH2 corresponding to the second drain electrode DE2 overlaps one side (upper side) of the second drain electrode DE2 and does not overlap the other side (lower side) of the second drain electrode DE2 to be spaced apart from the other side of the second drain electrode DE2. The other portion of the plurality of second gate insulating holes GH2 corresponding to the second drain electrode DE2 does not overlap one side (upper side) of the second drain electrode DE2 to be spaced apart from one side of the second drain electrode DE2 and overlaps the other side (lower side) of the second drain electrode DE2.

One side (lower side) of the portion of the plurality of second gate insulating layer holes GH2 corresponding to the second drain electrode DE2 and the other side (lower side) of the second drain electrode DE2 are spaced apart from each other by the first distance d1, and the other side (upper side) of the other portion of the plurality of second gate insulating layer holes GH2 corresponding to the second drain electrode DE2 and one side (upper side) of the second drain electrode DE2 are spaced apart from each other by the first distance d1. The second drain electrode DE2 has a width of the third distance d3.

The other side (lower side) of the plurality of second gate insulating layer holes GH2 overlapping one side (lower side) of the second source electrode SE2 and the other side (upper side) of the plurality of second gate insulating layer holes GH2 overlapping the other side (lower side) of the second drain electrode DE2 are spaced apart from each other by the fourth distance d4, and the other side (lower side) of the plurality of second gate insulating layer holes GH2 overlapping the second source electrode SE2 and the other side (upper side) of the plurality of second gate insulating layer holes GH2 overlapping one side (upper side) of the second drain electrode DE2 are spaced apart from each other by the fourth distance d4.

As a result, a gap between the second gate insulating layer hole GH2 corresponding to the second source electrodes SE2 disposed in a line along the vertical direction and the second gate insulating layer hole GH2 corresponding to the second drain electrode DE2 may be uniformly kept as the fourth distance d4.

In FIG. 9C, the plurality of second gate insulating holes GH2 corresponding to the second source electrode SE2 in a lower portion DP of the second stage transistor T2 are disposed in a zigzag line along the horizontal direction. A portion of the plurality of second gate insulating layer holes GH2 corresponding to the second source electrode SE2 overlaps one side (lower side) of the second source electrode SE2 and does not overlap the other side (upper side) of the second source electrode SE2 to be spaced apart from the other side of the second source electrode SE2. The other portion of the plurality of second gate insulating holes GH2 corresponding to the second source electrode SE2 overlaps the other side (upper side) of the second source electrode SE2 and does not overlap one side (lower side) of the second source electrode SE2 to be spaced apart from one side of the second source electrode SE2.

One side (upper side) of the portion of the plurality of second gate insulating layer holes GH2 corresponding to the second source electrode SE2 and the other side (upper side) of the second source electrode SE2 are spaced apart from each other by the first distance d1, and the other side (lower side) of the other portion of the plurality of second gate insulating layer holes GH2 corresponding to the second source electrode SE2 and one side (lower side) of the second source electrode SE2 are spaced apart from each other by the first distance d1. The second source electrode SE2 has a width of the third distance d3.

The plurality of second gate insulating layer holes GH2 corresponding to the second drain electrode DE2 are disposed in a straight line along the horizontal direction to overlap one side (upper side) of the second drain electrode DE2 and are spaced apart from the other side (lower side) of the second drain electrode DE2 not to overlap the other side of the second drain electrode DE2.

One side (lower side) of the plurality of second gate insulating layer holes GH2 corresponding to the second drain electrode DE2 and the other side (lower side) of the second drain electrode DE2 are spaced apart from each other by the first distance d1, and one side (lower side) of the plurality of second gate insulating layer holes GH2 corresponding to the second drain electrode DE2 and one side (lower side) of the second active layer AL2 are spaced apart from each other by the second distance d2. The second drain electrode DE2 has a width of the third distance d3.

In FIG. 10A, the buffer layer 158 is formed on the entire substrate 150. Next, after a semiconductor material is deposited on the buffer layer 158 in the non-display area NDA, the second active layer AL2 is formed through a photolithographic process. Next, after a metallic material is deposited on the second active layer AL2, the metal layer 166 is formed on both end portions of the second active layer AL2 through a photolithographic process.

The second active layer AL2 in the non-display area NDA may have the same layer and the same material as the active layer 160 of the subpixel SP1 to SP4 in the display area DA.

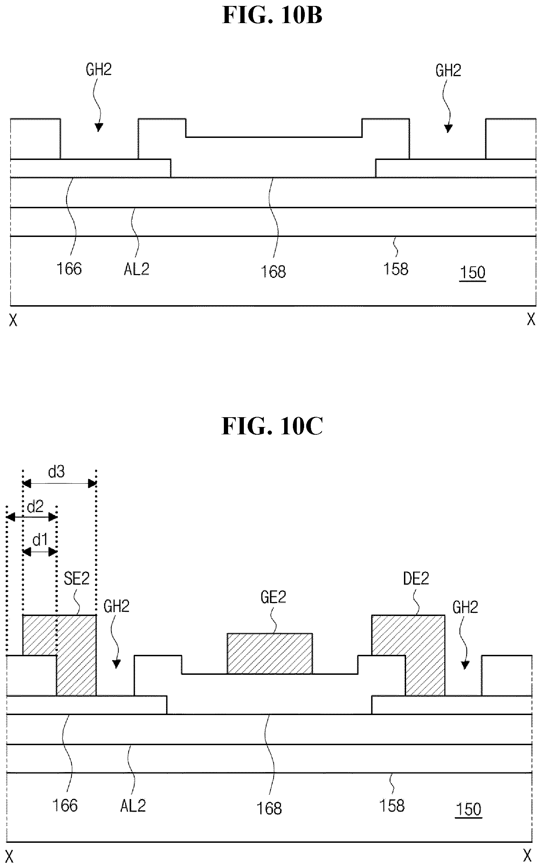

In FIG. 10B, after an insulating material is deposited on the metal layer 166, the gate insulating layer 168 having the plurality of second gate insulating layer holes GH2 is formed through a photolithographic process.

The plurality of second gate insulating layer holes GH2 expose the metal layer 166.

In another example, the metal layer 166 may be omitted, and the plurality of second gate insulating layer holes GH2 may expose the source region and the drain region of the second active layer AL2.

In FIG. 10C, after a metallic material is deposited on the gate insulating layer 168, the second gate electrode GE2, the second source electrode SE2 and the second drain electrode DE2 are formed through a photolithographic process.

The second gate electrode GE2, the second source electrode SE2 and the second drain electrode DE2 in the non-display area NDA may have the same layer and the same material as each other and may have the same layer and the same material as the gate electrode 170, the source electrode 172 and the drain electrode 174 of the subpixel SP1 to SP4 in the display area DA.

For example, the second gate electrode GE2, the second source electrode SE2 and the second drain electrode DE2 may be formed through a wet etching method.

The second gate electrode GE2 is disposed on the gate insulating layer 168, and each of the second source electrode SE2 and the second drain electrode DE2 is disposed to overlap one side of the plurality of second gate insulating holes GE2 and be spaced apart from the other side of the plurality of second gate insulating layer holes GE2.

As a result, each of the second source electrode SE2 and the second drain electrode DE2 may be disposed on the gate insulating layer 168 adjacent to the plurality of second gate insulating layer holes GH2 and on a portion of the metal layer 166 in the plurality of second gate insulating layer holes GH2.

One side of the plurality of second gate insulating layer holes GH2 and the other side of the second source electrode SE2 may be spaced apart from each other by the first distance d1, and one side of the plurality of second gate insulating layer holes GH2 and one side of the second active layer AL2 may be spaced apart from each other by the second distance d2. The second source electrode SE2 may have a width of the third distance d3.

One side of the plurality of second gate insulating layer holes GH2 and the other side of the second drain electrode DE1 may be spaced apart from each other by the first distance d1, and one side of the plurality of second gate insulating layer holes GH2 and the other side of the second active layer AL2 may be spaced apart from each other by the second distance d2. The second drain electrode DE2 may have a width of the third distance d3.

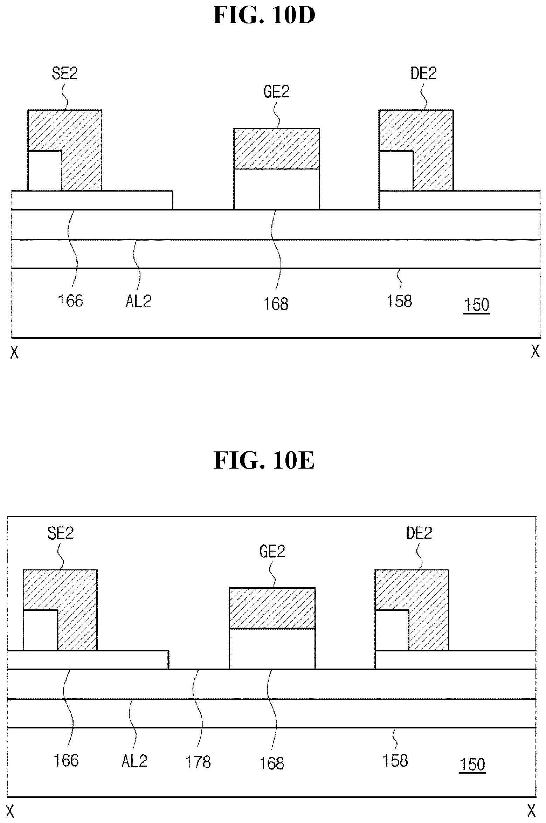

In FIG. 10D, the gate insulating layer 168 is formed under a whole of the second gate electrode GE2, a portion of the second source electrode SE2 and a portion of the second drain electrode DE2 by selectively removing the gate insulating layer 168 exposed outside lower portions of the second gate electrode GE2, the second source electrode SE2 and the second drain electrode DE2 using the second gate electrode GE2, the second source electrode SE2 and the second drain electrode DE2 as an etching mask.

For example, the gate insulating layer 168 may be formed through a dry etching method.

While the second gate electrode GE2, the second source electrode SE2, the second drain electrode DE2 and the gate insulating layer 168 are etched, a side portion (edge portion) of each of the second source electrode SE2 and the second drain electrode DE2 overlapping a sidewall (step difference portion) of the plurality of second gate insulating layer holes GH2 and exposed in the plurality of second gate insulating layer holes GH2 may be eroded by an etchant or an etching gas. When both sides of each of the second source electrode SE2 and the second drain electrode DE2 are disposed in the plurality of second gate insulating layers GH2, each of the second source electrode SE2 and the second drain electrode DE2 may be disconnected.

In the display device 110 according to an example of the present disclosure, one side of each of the second source electrode SE2 and the second drain electrode DE2 is disposed in the plurality of second gate insulating layer holes GH2, and the other side of each of the second source electrode SE2 and the second drain electrode DE2 is disposed outside the plurality of second gate insulating layer holes GH2. As a result, while the second gate electrode GE2, the second source electrode SE2, the second drain electrode DE2 and the gate insulating layer 168 are etched, the disconnection of each of the second source electrode SE2 and the second drain electrode DE2 is reduced or minimized.

Further, since the plurality of second gate insulating layer holes GH2 are disposed in a zigzag line along the horizontal direction, an area of the second source electrode SE2 and the second drain electrode DE2 contacting the metal layer 166 is uniformly kept and the uniformity of a contact resistance is improved even when a misalignment occurs along the vertical direction. As a result, the property uniformity of the second stage transistor T2 is improved and the reliability of the display device 110 is improved.

In FIG. 10E, the interlayer insulating layer 178 is formed on the second gate electrode GE2, the second source electrode SE2 and the second drain electrode DE2 over the entire substrate 150 to complete the second stage transistor T2.

Although the plurality of second gate insulating layer holes GH2 of the upper portion and the lower portion are disposed in a line along the horizontal direction for obtaining the second distance d2 in an example of FIG. 8, an upper side and a lower side of the second active layer AL2 may extend toward an upper direction and a lower direction, respectively, to obtain the second distance d2, and the plurality of second gate insulating layer holes GH2 of the upper portion and the lower portion may be disposed in a zigzag line along the horizontal direction in another example.

Consequently, in the display device 110 according to an example of the present disclosure, one side of each of the first and second source electrodes SE1 and SE2 and the first and second drain electrodes DE1 and DE2 of the first and second stage transistors T1 and T2 in the non-display area NDA is disposed in the plurality of first gate insulating layer holes GH1 and the plurality of second gate insulating layer holes GH2, and the other side of each of the first and second source electrodes SE1 and SE2 and the first and second drain electrodes DE1 and DE2 is disposed outside the plurality of first gate insulating layer holes GH1 and the plurality of second gate insulating layer holes GH2. As a result, disconnection of each of the first and second source electrodes SE1 and SE2 and the first and second drain electrodes DE1 and DE2 is reduced or minimized while the first and second gate electrodes GE1 and GE2, the first and second source electrodes SE1 and SE2, the first and second drain electrodes DE1 and DE2 and the gate insulating layer 168 are etched.

Further, since the plurality of second gate insulating layer holes GH2 of the second stage transistor T2 in the non-display area NDA are disposed in a zigzag line along the horizontal direction, an area of the second source electrode SE2 and the second drain electrode DE2 contacting the metal layer 166 is uniformly kept and the uniformity of a contact resistance is improved even when a misalignment occurs along the vertical direction. As a result, the property uniformity of the second stage transistor T2 is improved and the reliability of the display device 110 is improved.

It will be apparent to those skilled in the art that various modifications and variation can be made in the present disclosure without departing from the scope of the disclosure. Thus, it is intended that the present disclosure cover the modifications and variations of this disclosure provided they come within the scope of the appended claims.

## Claims

1. A display device, comprising:
a substrate having a display area including a subpixel and a non-display area surrounding the display area;
a driving transistor and a light emitting diode in the subpixel on the substrate; and
a second stage transistor in the non-display area on the substrate,
wherein the second stage transistor includes a second active layer, a second gate electrode, a second source electrode and a second drain electrode, and
wherein a gate insulating layer between the second active layer and the second source electrode and between the second active layer and the second drain electrode exposes the second active layer and has a plurality of second gate insulating layer holes in a zigzag line along a horizontal direction parallel to the second source electrode and the second drain electrode.

2. The display device of claim 1, wherein a first portion of the plurality of second gate insulating layer holes corresponding to the second source electrode overlaps a first side of the second source electrode and is spaced apart from a second side of the second source electrode, and a second portion of the plurality of second gate insulating layer holes corresponding to the second source electrode is spaced apart from the first side of the second source electrode and overlaps the second side of the second source electrode, and
wherein a first portion of the plurality of second gate insulating layer holes corresponding to the second drain electrode overlaps a first side of the second drain electrode and is spaced apart from a second side of the second drain electrode, and a second portion of the plurality of second gate insulating layer holes corresponding to the second drain electrode is spaced apart from the first side of the second drain electrode and overlaps the second side of the second drain electrode.

3. The display device of claim 2, wherein the plurality of second gate insulating layer holes corresponding to the second source electrode in an upper portion of the second stage transistor overlap a first side of the second source electrode and are spaced apart from a second side of the second source electrode to be disposed in a straight line along the horizontal direction, and
wherein the plurality of second gate insulating layer holes corresponding to the second drain electrode in a lower portion of the second stage transistor overlap a first side of the second drain electrode and are spaced apart from a second side of the second drain electrode to be disposed in a straight line along the horizontal direction.

4. The display device of any preceding claim, wherein the second gate electrode includes a plurality of gate vertical parts and a plurality of gate horizontal parts connected to each other and symmetrically disposed with respect to a central line along a vertical direction crossing the horizontal direction,
wherein the second source electrode includes a source vertical part corresponding to the central line and a plurality of source horizontal parts extending from the source vertical part along the horizontal direction, and
wherein the second drain electrode includes a drain vertical part at both sides of the central line and a plurality of drain horizontal parts extending from the drain vertical part along the horizontal direction.

5. The display device of claim 4, wherein the plurality of gate horizontal parts, the plurality of source horizontal parts and the plurality of drain horizontal parts are disposed along the horizontal direction, and
wherein the plurality of gate horizontal parts, the plurality of source horizontal parts and the plurality of drain horizontal parts are spaced apart from and parallel to each other along the vertical direction and are alternately disposed along the vertical direction.

6. The display device of any preceding claim, further comprising a first stage transistor disposed in the non-display area on the substrate and having a ratio of a channel width with respect to a channel length smaller than a ratio of a channel width with respect to a channel length of the second stage transistor,
wherein the first stage transistor includes a first active layer, a first gate electrode, a first source electrode and a first drain electrode, and
wherein a gate insulating layer between the first active layer and the first source electrode and between the first active layer and the first drain electrode exposes the first active layer and has a plurality of first gate insulating layer holes disposed in a straight line along a horizontal direction parallel to the first source electrode and the first drain electrode.

7. The display device of any preceding claim, further comprising a metal layer between the second active layer and the second source electrode and between the second active layer and the second drain electrode.

8. The display device of any preceding claim, wherein a gate driving unit configured to generate a gate signal supplied to the display area and having a plurality of blocks is disposed in the non-display area,
wherein the plurality of blocks include a clock signal block, a high level voltage block, a stage circuit block and a low level voltage block, and
wherein a gate line transmitting the gate signal extends from the stage circuit block to the display area through the low level voltage block.

9. The display device of claim 8, wherein the gate signal includes a scan signal and a sensing signal, and
wherein the subpixel comprises:
a switching transistor switched according to the scan signal and connected to a data signal;
a storage capacitor connected to the switching transistor;
a driving transistor switched according to a voltage of a first capacitor electrode of the storage capacitor and connected to a high level voltage;
a reference transistor switched according to the sensing signal and connected to the storage capacitor, the driving transistor and a reference signal; and
the light emitting diode connected to the storage capacitor, the driving transistor, the reference transistor and a low level voltage.

10. The display device of claim 9, wherein at least one of the switching transistor, the driving transistor and the reference transistor includes an oxide semiconductor thin film transistor.

11. The display device of claim 9, wherein the stage circuit block generates the scan signal and transmits the scan signal to the switching transistor through a gate line, and the stage circuit block generates the sensing signal and transmits the sensing signal to the reference transistor through the gate line.

12. The display device of any preceding claim, further comprising:
a light shielding layer in the subpixel on the substrate;
a buffer layer between the light shielding layer and the driving transistor;
an interlayer insulating layer between the driving transistor and the light emitting diode;
an overcoat layer between the interlayer insulating layer and the light emitting diode;
a bank layer on the overcoat layer; and
first and second encapsulating layers sequentially on the light emitting diode.

13. The display device of claim 12, wherein the driving transistor includes an active layer on the buffer layer corresponding to the light shielding layer, a gate insulating layer and a gate electrode sequentially on a central portion of the active layer, a source electrode contacting a first end portion of the active layer and the light shielding layer and a drain electrode contacting a second end portion of the active layer.

14. The display device of claim 12 or 13, wherein the light emitting diode includes a first electrode on the overcoat layer and connected to the source electrode, an emitting layer on the first electrode and a second electrode on the emitting layer, and
wherein the bank layer covers an edge portion of the first electrode and includes an opening exposing a central portion of the first electrode.
